# EUROPÄISCHE PATENTSCHRIFT

(11) **EP 0 610 228 B1**
(45) Veröffentlichungstag und Bekanntmachung des Hinweises auf die Patenterteilung: **25.06.1997**
(21) Anmeldenummer: 92919360.5
(22) Anmeldetag: 17.09.1992
(51) Int. Cl.: H01L 29/08, H01L 27/02

(54) **P-KANAL-TRANSISTOR**
P-CHANNEL TRANSISTOR
TRANSISTOR A CANAL P

(30) Priorität: 23.10.1991 DE 4134879
(43) Veröffentlichungstag der Anmeldung: 17.08.1994
(73) Patentinhaber: ROBERT BOSCH GMBH, 70442 Stuttgart (DE)
(72) Erfinder: BYRNE, Gerard, D-7407 Rottenburg-Wurmlingen (DE)
(86) Internationale Anmeldenummer: DE9200794
(87) Internationale Veröffentlichungsnummer: WO9308604

(56) Entgegenhaltungen:
- EP-A- 0 121 096
- EP-A- 0 319 047
- IEEE ELECTRON DEVICE LETTERS Bd. EDL-7, Nr. 1, Januar 1986, New York, US, Seiten 20-22; N. SHIONO et al.: 'A 64K SRAM with high immunity from heavy ion induced latch-up'

## Beschreibung

### Stand der Technik

Die Erfindung betrifft einen P-Kanal-Transistor mit einer Drainelektrode, einer Sourceelektrode, einer Gateelektrode und einer Bulkelektrode, wobei die Drain- und Sourceelektrode als p-Gebiete in einer N-Wanne ausgebildet sind und die Wanne selbst in einem umgebenden P-Gebiet eingebettet ist.

Gegebenenfalls ist ein verpolfester Anschluß der N-Wanne erforderlich, die die Bauteile, wie Widerstände, Kapazitäten. Z-Dioden und MOS-Transistoren, in Bipolar- und CMOS-Ausführung beinhalten kann. Um einen derartigen verpolfesten Anschluß zu erreichen, sind mehrere Möglichkeiten bekannt:
a) Man kann eine sogenannte floatende Wanne vorsehen, bei der zwar eine Verpolfestigkeit gewährleistet ist und in der auch andere Bauelemente untergebracht werden können, jedoch treten insbesondere bei höheren Temperaturen hohe Leckströme auf. P-Gebiete in dieser Wanne können als Kollektor bzw. als wannentragender Emitter funktionieren. Ein solches P-Gebiet in der N-Wanne wird zum Emitter eines parasitären PNP-Transistors, dessen Kollektorstrom der Leckstrom ist, der zwischen die N-Wanne und das umgebende P-Gebiet fließt.
b) Eine weitere Möglichkeit, eine Verpolfestigkeit zu erreichen, besteht darin, einen Teilkollektor eines PNP-Transistors an der N-Wanne anzuschließen. Hierdurch tritt jedoch ein Mehraufwand bei der Herstellung und Verdrahtung auf, da der PNP-Transistor in einer getrennten zweiten Wanne untergebracht werden muß.
c) Eine Verpolfestigkeit kann auch dadurch erreicht werden, daß die Wanne durch Zwischenschaltung einer PNP-Diode um eine Diodenspannung unterhalb dem positiven Potential der Betriebsspannung (U⁺) geführt wird. Nachteilig an dieser Lösung ist es, daß die Injektion durch andere auf U⁺ liegende P-Gebiete nicht vollständig verhindert werden kann. Darüber hinaus entsteht wiederum bei der Herstellung eine größere Flächenbeanspruchung.
d) Eine weitere Möglichkeit besteht darin, U⁺ über einen Widerstand an die Wanne anzulegen. Hierbei fließt aber bei Verpolung ein Strom, der sich aus dem Widerstandswert ergibt. Durch den relativ hochohmigen Widerstand wird jedoch ebenfalls eine relativ große Fläche beansprucht.

### Vorteile der Erfindung

Der erfindungsgemäße P-Kanal-Transistor mit den Merkmalen des Hauptanspruchs hat den Vorteil, daß bei einer geringen Flächenbeanspruchung eine Verpolfestigkeit erreicht werden kann. Insbesondere kann der P-Kanal ohne große Flächenbeanspruchung in der gleichen N-Wanne untergebracht werden, in der auch noch weitere Bauelemente untergebracht werden können, d. h. es ist keine zusätzliche Wanne nötig. Die einzige Wanne kann auf dem Potential U⁺ (im nichtverpolten Einsatz) gehalten werden. Substrat-Leckströme können daher auch bei höherer Temperatur sehr gering gehalten werden. Insgesamt vereint die erfindungsgemäße Lösung die Vorteile der verschiedenen bekannten Lösungen, wobei deren Nachteile nicht in Kauf genommen werden müssen.

Die Gateelektrode liegt an einem Potential U_{G} < U⁺ -|U_{TH}|, das niedriger als das positive Potential der Betriebsspannung ist, wobei U_{TH} die Schwellspannung des p-Kanals ist. Diese Bedingung ist ausreichend, daß der Transistor angesteuert ist. Der Spannungsunterschied U⁺ - Wannenpotential bleibt dadurch kleiner als eine Diodenflußspannung, und es kann somit kein parasitärer PNP-Transistor in Flußrichtung betrieben werden.

Durch die in den Unteransprüchen aufgeführten Maßnahmen sind vorteilhafte Weiterbildungen und Verbesserungen des im Hauptanspruch angegebenen P-Kanal-Transistors möglich.

Die Bulkelektrode ist als zwischen den beiden P-Gebieten der Drain- und Sourceeleketrode angeordneter p-Kanal ausgebildet. Das p-Gebiet der Sourceelektrode ist mit einem n⁺-Gebiet in der Wanne kontaktiert, um die Bildung einer Schottky-Diode zu vermeiden. Dabei grenzt das n⁺-Gebiet zweckmäßigerweise räumlich an das p-Gebiet an.

Da in den meisten Fällen Masse als Gateanschluß ausreicht, kann eine einfache Anordnung vorgesehen werden. Da das Gate keine statische Stromaufnahme benötigt, reicht auch die P-Isolation als Masseanschluß aus. Hierbei wird zweckmäßigerweise die Gateelektrode mit einem p⁺-Gebiet in der P-Isolation kontaktiert, um die Bildung einer Schottky-Diode zu verhindern. Alternativ hierzu kann die Gateelektrode auch mit einer Leiterbahn kontaktiert sein, die mit dem Massepotential oder einem darüber liegenden Potential gemäß der vorstehend genannten Bedingung beaufschlagt ist.

### Zeichnung

Ein Ausführungsbeispiel der Erfindung ist in der Zeichnung dargestellt und in der nachfolgenden Beschreibung näher erläutert. Es zeigen:
- Fig. 1: eine Draufsicht auf das Layout des erfindungsgemäßen P-Kanal-Transistors als Ausführungsbeispiel,
- Fig. 2: eine Schnittdarstellung des in Fig. 1 dargestellten Transistors im Längsschnitt und
- Fig. 3: eine schaltungsmäßige Darstellung des in den Fig. 1 und 2 dargestellten Ausführungsbeispiel.

### Beschreibung des Ausführungsbeispiels

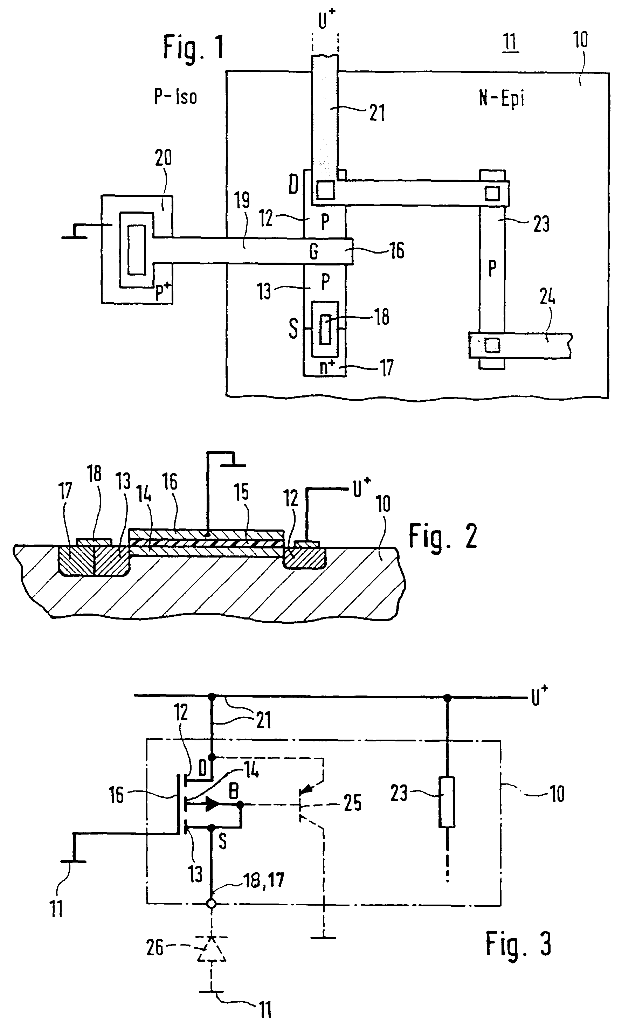

Bei dem in den Figuren 1 und 2 dargestellten Ausführungsbeispiel ist eine N-Wanne 10 (im folgenden als Wanne bezeichnet) in einem P-Isolations-Gebiet 11 (im folgenden als P-Iso bezeichnet) eingebettet. Zwei P-Gebiete in der Wanne 10 bilden die Drainelektrode 12 und die Sourceelektrode 13. Diese sind über eine als p-Kanal ausgebildete Bulkelektrode 14 miteinander verbunden, die ebenfalls als flache Schicht in der Wanne 10 enthalten ist. Über der Bulkelektrode 14 ist durch eine Isolationsschicht 15 getrennt eine ebenfalls flach ausgebildete Gateelektrode 16 angeordnet. Neben dem die Sourceelektrode 13 bildenden p-Gebiet ist ein n⁺-Gebiet 17 in der Wanne eingelassen, welches mit der Sourceelektrode 13 über eine äußere Kontaktierung 18 verbunden ist. Hierdurch ist die Sourceelektrode 13 ohne Bildung einer Schottky-Diode mit der Wanne 10 verbunden. Die Gateelektrode 16 ist über eine seitlich wegführende Verbindungsbahn 19 mit der P-Iso 11 verbunden. Hierzu ist die über der P-Iso 11 endende Verbindungsbahn 19 mit einem p⁺-Gebiet 20 kontaktiert, das zur Vermeidung der Bildung einer Schottky-Diode in die P-Iso 11 eingelassen ist. Die P-Iso 11 dient dabei als Masseanschluß, da die Gateelektrode 16 keine statische Stromaufnahme benötigt.

Die Drainelektrode 12 ist mit einer Leiterbahn 21 kontaktiert, die mit dem positiven Pol U⁺ der Betriebsspannung oder einer anderen spannung verbunden ist. Diese Leiterbahn 12 führt weiterhin zu einem als p-Gebiet ausgebildeten Widerstand 23, wobei dieses p-Gebiet ebenfalls in die Wanne 10 eingelassen ist. Eine weitere Leiterbahn 24 ist mit dem anderen Ende des Widerstandes 23 kontaktiert und führt zu weiteren, nicht dargestellten Bauelementen. Der Widerstand 23 ist dabei lediglich als Beispiel für weitere Bauelemente genannt, die ebenfalls in derselben Wanne 10 angeordnet sein können.

In Figur 3 ist der in den Figuren 1 und 2 dargestellte P-Kanal-Transistor als Schaltungssymbol dargestellt. Bei der beschriebenen Anordnung der Bereiche bildet sich wirkungsmäßig ein parasitärer PNP-Transistor 25 aus, der die Drainelektrode 12 über seine Emitter-Kollektor-Strecke mit dem umgebenden P-Gebiet verbindet. Die Basis liegt wirkungsmäßig an der Bulkelektrode 14, die wiederum mit der Sourceelektrode 13 verbunden ist. Zwischen dem umgebenden P-Gebiet und der Wanne 10 bildet sich wirkungsmäßig eine Diode 26 aus. Die wirkungsmäßig gebildeten Halbleiter sind gestrichelt dargestellt. Die übrige Beschaltung der Elektroden und Anschlüsse ist bereits aus den Figuren 1 und 2 bekannt.

Die Wirkungsweise des in den Figuren 1 bis 3 dargestellten P-Kanal-Transistors wird nun im folgenden beschrieben: Beim Anstieg der U⁺-Spannung folgt die Spannung an der Sourceelektrode 13 und der Bulkelektrode 14 infolge des parasitären PNP-Transistors 25 dieser Spannung und steigt ebenfalls an, bleibt jedoch eine Diodenflußspannung unterhalb U⁺. Übersteigt die Gate-Source-Spannung U_{GS} die Schwellspannung U_{TH} des P-Kanals, so wird dieser aktiv und zieht das Potential an der Sourceelektrode 13 und das der daran angeschlossenen Wanne 10 auf das Potential der Drainelektrode 12 hoch. Damit wird der parasitäre PNP-Transistor 25 abgeschaltet, und Leckströme zum Substrat 11 hin werden sehr gering.

Bei einer Verpolung wird das Potential U⁺ gegenüber Masse negativ, so das der P-Kanal angeschaltet bleibt. U⁺ kann bis zur Drain-Source-Durchbruchspannung ins Nepative gehen. ohne daß ein wesentlicher Strom fließt. Der parasitäre PNP-Transistor 25 ist bei der Verpolung ohnehin gesperrt.

## Patentansprüche

1. P-Kanal-Transistor mit einer Drainelektrode (12), einer Sourceelektrode (13) und einer Gateelektrode (16), wobei die Drainelektrode (12) und die Sourceelektrode (13) als p-Gebiete in einer n-Wanne (10) ausgebildet sind und die n-Wanne (10) selbst in einem umgebenden p-Gebiet (11) eingebettet ist, wobei die Drainelektrode (12) am positiven Pol (U⁺) einer Betriebsspannung liegt, die Sourceelektrode (13) mit der n-Wanne (10) über einen ohmischen Kontakt verbunden ist, und die Gateelektrode (16) an einem Potential U_{G} < U⁺ - |U_{TH}| liegt, das niedriger als das positive Potential (U⁺) der Betriebsspannung ist, wobei U_{TH} die Schwellspannung des p-Kanals ist.

2. Transistor nach Anspruch 1, dadurch gekennzeichnet, daß das p-Gebiet der Sourcelektrode (13) mit einem n⁺-Gebiet (17) in der Wanne (10) kontaktiert ist.

3. Transistor nach Anspruch 2, dadurch gekennzeichnet, daß das n⁺-Gebiet (17) räumlich am p-Gebiet Sourceelektrode (13) angrenzt.

4. Transistor nach einem der vorhergehenden Ansprüche, dadurch gekennzeichnet, daß die Drainelektrode (12) an einer Leiterbahn (21) kontaktiert ist, die mit dem positiven Pol (U⁺) der Betriebsspannung verbunden ist.

5. Transistor nach Anspruch 1, dadurch gekennzeichnet, daß die Gateelektrode (16) an Masse liegt.

6. Transistor nach Anspruch 1 oder 5, dadurch gekennzeichnet, daß die Gateelektrode (16) mit einem p⁺-Gebiet-Gebiet (20) im P-Isolations-Gebiet (11) kontaktiert ist.

7. Transistor nach Anspruch 1 oder 5, dadurch gekennzeichnet, daß die Gateelektrode (16) mit einer an Masse liegenden Leiterbahn kontaktiert ist.

## Claims

1. p-Channel transistor having a drain electrode (12), a source electrode (13) and a gate electrode (16), the drain electrode (12) and the source electrode (13) being constructed as p-regions in an n-well (10) and the n-well (10) itself being embedded in a surrounding p-region (11), the drain electrode (12) being connected to the positive pole (U⁺) of an operating voltage, the source electrode (13) being connected to the n-well (10) via an ohmic contact (17, 18), and the gate electrode (16) being connected to a potential U_{G} < U⁺ - ¦U_{TH}¦ which is lower than the positive potential (U⁺) of the operating voltage, U_{TH} being the threshold voltage of the p-channel.

2. Transistor according to Claim 1, characterized in that the p-region of the source electrode (13) is contacted with an n⁺-region (17) in the well (10).

3. Transistor according to Claim 2, characterized in that the n⁺-region (17) spatially adjoins the p-region of the source electrode (13).

4. Transistor according to one of the preceding claims, characterized in that the drain electrode (12) is contacted with a conductor track (21) which is connected to the positive pole (U⁺) of the operating voltage.

5. Transistor according to Claim 1, characterized in that the gate electrode (16) is connected to a frame.

6. Transistor according to Claim 1 or 5, characterized in that the gate electrode (16) is contacted with a p⁺-region (20) in the P-insulation region (11).

7. Transistor according to Claim 1 or 5, characterized in that the gate electrode (16) is contacted with a conductor track connected to a frame.

## Revendications

1. Transistor à canal P comprenant une électrode de drain (12), une électrode de source (13) et une grille (16), dans lequel l'électrode de drain (12) et l'électrode de source (13) sont constituées sous la forme de zones p dans une cuvette n (10) et la cuvette n (10) est elle-même noyée dans une zone p (11) environnante,
caractérisé en ce que
l'électrode de drain (12) se trouve sur le pôle positif (U⁺) d'une tension de fonctionnement, l'électrode de source (13) est reliée à la cuvette n (10) par l'intermédiaire d'un contact ohmique (17, 18) et l'électrode de grille (16) se trouve à un potentiel U_{G} < U⁺ - |U_{TH}|, qui est inférieur au potentiel positif (U⁺) de la tension de fonctionnement, U_{TH} étant la tension de seuil du canal p.

2. Transistor selon la revendication 1,
caractérisé en ce que
la zone p de l'électrode de source (13) est mise en contact avec une zone n⁺ (17) dans la cuvette (10).

3. Transistor selon la revendication 2,
caractérisé en ce que
la zone n⁺ (17) est adjacente dans l'espace à la zone p de l'électrode de source (13).

4. Transistor selon l'une des revendications précédentes,
caractérisé en ce que
l'électrode de drain (12) est mise en contact avec une piste conductrice (21), qui est reliée au pôle positif (U⁺) de la tension de fonctionnement.

5. Transistor selon la revendication 1,
caractérisé en ce que
la grille (16) est à la masse.

6. Transistor selon la revendication 1 ou 5,
caractérisé en ce que
la grille (16) est mise en contact avec une zone p⁺ (20) dans la zone d'isolation P (11).

7. Transistor selon la revendication 1 ou 5,
caractérisé en ce que
la grille (16) est mise en contact avec une piste conductrice se trouvant à la masse.
